# EUROPÄISCHE PATENTANMELDUNG

(11) **EP 0 975 077 A1**
(43) Veröffentlichungstag der Anmeldung: **26.01.2000**
(21) Anmeldenummer: 98113928.0
(22) Anmeldetag: 24.07.1998
(51) Int. Cl.: H02B 1/28, H05K 5/02, F16T 1/45, F16K 24/00

(54) **Be- und Entlüftungs- und Kondenswasserablassverschraubung**

(71) Anmelder: Lagra Elektrotechnik GmbH, 69245 Bammental (DE)
(72) Erfinder: Kloss, Achim, 69115 Heidelberg (DE); Landgraf, Gerhard, 69151 Neckargemünd (DE)
(74) Vertreter: Meyer-Roedern, Giso, Dr.

(57) **Zusammenfassung**

Die Verschraubung hat einen Prismenkörper (10) in Form eines Außensechskants mit einer im Durchmesser abgestuften, mittigen Zylinderbohrung (16). Die innere Partie größeren Durchmessers der Zylinderbohrung (16) ist als Innengewindebohrung (18) ausgebildet. Außen bildet die Zylinderbohrung (16) eine Ringstufe (20), an der ein in den Prismenkörper (10) eingelegtes Sieb (14) zur Anlage kommt. Weiter hat die Verschraubung einen hohlzylindrischen Gewindestutzen (12) mit einem in das Innengewinde (18) des Prismenkörpers (10) passenden Außengewinde (22) und mit einem Flansch (24) mit Außensechskant an seinem inneren Ende. Der Flansch (24) ist mit wenigstens einem durchgehenden Schlitz (26) versehen.

## Beschreibung

Die Erfindung betrifft eine Be- und Entlüftungs- und Kondenswasserablaßverschraubung.

Derartige Verschraubungen sind aus der Praxis bekannt. Sie dienen dazu, einen Druckausgleich zwischen dem Innern eines Gehäuses und der Umgebungsluft herzustellen und Kondenswasser aus dem Gehäuse abzulassen. Be- und Entlüftungs- und Kondenswasserablaßverschraubungen kommen insbesondere an elektrischen Schaltschränken zum Einsatz. Sie sollen beim Erwärmen und Abkühlen einen Luftaustausch ermöglichen, Kondenswasser aus dem Schaltschrank ableiten und ein Eindringen von Spritzwasser und Verunreinigungen verhindern.

Aufgabe der Erfindung ist es, eine im Aufbau unaufwendige, bequem zu montierenden Be- und Entlüftungs- und Kondenswasserablaßverschraubung zu schaffen, die auf dem Boden stehendes Wasser plan zu fassen ermöglicht.

Die diese Aufgabe lösende Verschraubung weist einen Prismenkörper in Form eines Außensechskants auf, der eine im Durchmesser abgestufte mittige Zylinderbohrung hat. Die innere Partie größeren Durchmessers der Bohrung ist als Innengewindebohrung ausgebildet. Außen bildet die Bohrung eine Ringstufe, an der ein in den Prismenkörper eingelegtes Sieb zur Anlage kommt. Desweiteren ist ein hohlzylindrischer Gewindestutzen vorgesehen, der ein in das Innengewinde des Prismenkörper passendes Außengewinde und an seinem inneren Ende einen Flansch mit Außensechskant hat. Der Flansch ist mit wenigstens einem durchgehenden Schlitz versehen.

Bei einer bevorzugten Ausführungsform hat der Flansch Schlitze in der Mitte einer jeden Sechskantfläche.

Die Außensechskante von Prismenkörper und Flansch sind vorzugsweise gleich groß. Die Schlauchverschraubung wird so mit gleich großen Schraubenschlüsseln montiert.

Bei einer bevorzugten Ausführungsform bestehen der Prismenkörper und der Gewindestutzen aus Messing und das Sieb aus Edelstahl. Das Sieb ist korrosionsfrei.

Die Erfindung wird im folgenden anhand eines in der Zeichnung dargestellten Ausführungsbeispiels näher erläutert. Es zeigen:

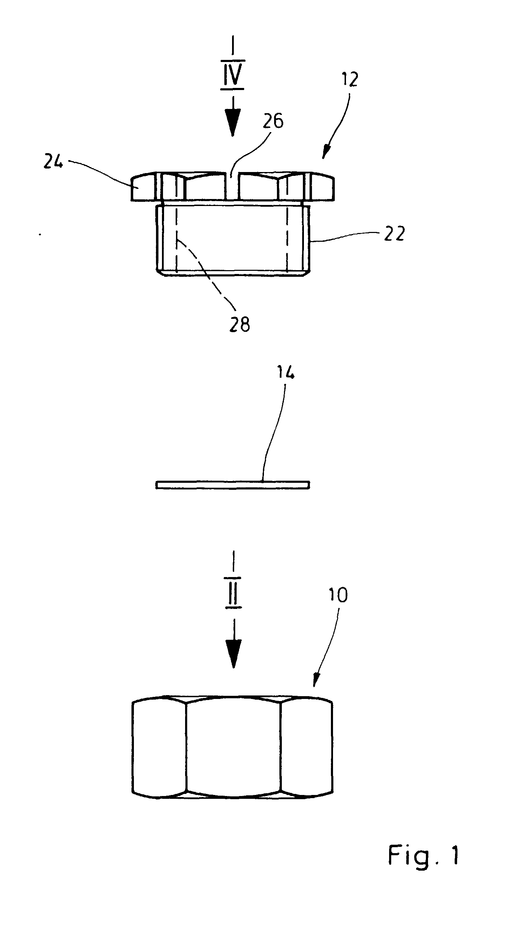

- Fig. 1: die Explosionszeichnung einer Be- und Entlüftungs- und Kondenswasserablaßverschraubung mit einem Prismenkörper und mit einem Gewindestutzen in Seitenansicht;

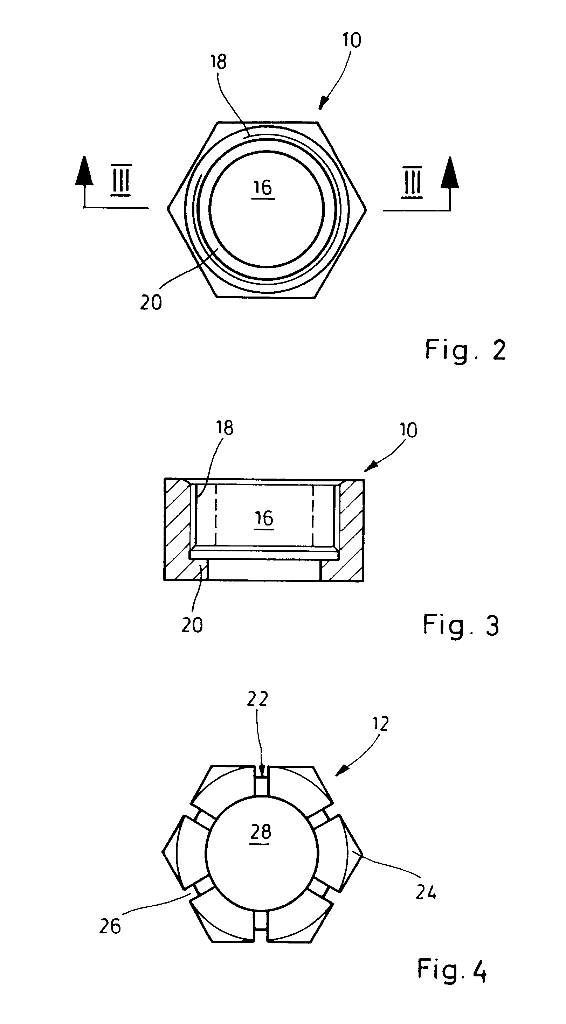

- Fig. 2: eine Draufsicht auf den Prismenkörper mit Blick in Richtung II von Fig. 1;
- Fig. 3: einen Schnitt durch den Prismenkörper nach III - III von Fig. 2; und
- Fig. 4: eine Draufsicht auf den Gewindestutzen mit Blick in Richtung IV von Fig. 1.

Die Verschraubung besteht aus einem Prismenkörper 10, einem Gewindestutzen 12 und einem Sieb 14.

Der Prismenkörper 10 hat die Form eines Außensechskants. Er weist eine mittige, im Durchmesser abgestufte Zylinderbohrung 16 auf, deren innere Partie größeren Durchmessers als Innengewindebohrung 18 ausgebildet ist. Außen bildet die Bohrung 16 eine Ringstufe 20, an der das in den Prismenkörper 10 eingelegte Sieb 14 zur Anlage kommt.

Der Gewindestutzen 12 ist hohlzylindrisch. Er hat ein Außengewinde 22, das in das Innengewinde 18 des Prismenkörpers 10 paßt.

Am inneren Ende des Gewindestutzens 12 ist ein Flansch 24 mit einem Außensechskant vorgesehen, der von gleicher Größe wie der Außensechskant des Prismenkörpers 10 ist.

Der Flansch 24 ist in der Mitte einer jeden Sechskantfläche über seine volle Höhe geschlitzt 26.

Zur Montage der Verschraubung wird ein Loch in den Boden eines Schaltschranks o. ä. gebohrt, durch das der Gewindestutzen 12 paßt. Es empfiehlt sich eine Anbringung von Verschraubungen an allen vier Ecken des Schaltschranks, der entsprechend verbohrt wird.

Der Gewindestutzen 12 wird von innen durch das Loch hindurchgesteckt und der Prismenkörper 10 mit dem eingelegten Sieb 14 von außen aufgeschraubt. Flansch 24 und Prismenkörper 10 spannen den Boden des Schaltschranks zwischen sich ein.

Die Schlitze 26 in dem Flansch 24 ermöglichen einen Wassereintritt in die Zylinderöffnung 28 des Gewindestutzens 12 auf Bodenhöhe des Schaltschranks. Das Wasser läuft durch das Sieb nach unten ab.

### Liste der Bezugszeichen

- 10: Prismenkörper
- 12: Gewindestutzen
- 14: Sieb
- 16: Zylinderbohrung
- 18: Innengewinde
- 20: Ringstufe
- 22: Außengewinde
- 24: Flansch
- 26: Schlitz
- 28: Zylinderöffnung

## Patentansprüche

1. Be- und Entlüftungs- und Kondenswasserablaßverschraubung insbesondere für einen Schaltschrank mit einem Prismenkörper (10) in Form eines Außensechskants, der eine im Durchmesser abgestufte mittige Zylinderbohrung (16) hat, deren innere Partie größeren Durchmessers als Innengewindebohrung (18) ausgebildet ist und die außen eine Ringstufe (20) bildet, an der ein in den Prismenkörper (10) eingelegtes Sieb (14) zur Anlage kommt, und mit einem hohlzylindrischen Gewindestutzen (12), der ein in das Innengewinde (18) des Prismenkörpers (10) passendes Außengewinde (22) und an seinem inneren Ende einen Flansch (24) mit Außensechskant hat, der mit wenigstens einem durchgehenden Schlitz (26) versehen ist.

2. Verschraubung nach Anspruch 1, dadurch gekennzeichnet, daß der Flansch (24) Schlitze (26) in der Mitte einer jeden Sechskantfläche hat.

3. Verschraubung nach Anspruch 1 oder 2, dadurch gekennzeichnet, daß die Außensechskante von Prismenkörper (10) und Flansch (24) gleich groß sind.

4. Verschraubung nach einem der Ansprüche 1 bis 3, dadurch gekennzeichnet, daß der Prismenkörper (10) und der Gewindestutzen (12) aus Messing und das Sieb (14) aus Edelstahl besteht.
